# EUROPEAN PATENT APPLICATION

(11) **EP 2 469 996 A2**
(43) Date of publication of application: **27.06.2012**
(21) Application number: 11192626.7
(22) Date of filing: 08.12.2011
(51) Int. Cl.: H05K 7/20

(54) **Cooling device and power conversion device including the same**

(30) Priority: 27.12.2010 JP 2010289095
(71) Applicant: Hitachi, Ltd., Chiyoda-ku Tokyo 100-8280 (JP)
(72) Inventor: Funakoshi, Sunao, Tokyo, Tokyo 100-8220 (JP); Yasuda, Yosuke, Tokyo, Tokyo 100-8220 (JP); Tanaka, Takeshi, Tokyo, Tokyo 100-8220 (JP); Hishida, Akihiro, Tokyo, Tokyo 100-8220 (JP)
(74) Representative: Paget, Hugh Charles Edward

(57) **Abstract**

It is an object of this invention to reduce the size and weight of a heat pipe cooling device for an electric conversion device by making the temperature of a heat receiving member with attached power semiconductor devices uniform. In a cooling device which transmits heat generated from power devices attached to the surface of a heat block to fins by heat pipes and provides cooling by natural convection or forced convection of air flowing among the fins, parts extending upward toward the fins of ones on the downstream side of the heat pipes are arranged more densely than upwardly extending parts of ones on the upstream side of the heat pipes.

## Description

### BACKGROUND OF THE INVENTION

### Field of the Invention

The present invention relates to a cooling device and a power conversion device including the same.

### Description of the Related Art

A power conversion device is intended to control an electric motor which drives a car such as an electric railway car and is placed, e.g., under the floor of a car. Due to the limited space under the floor of a car, there is a need for reduction in the size of a power conversion device. Additionally, heat generated in a power semiconductor device of an electric conversion device has been increasing with increase in the speed of a car. The reduction in size and the increase in output power of an electric conversion device increase the heat density of a power semiconductor device. Demand for improvement in the performance of a cooling device of an electric conversion device is thus growing. Cooling devices generally adopt a structure in which a heat receiving member such as an aluminum block includes a power semiconductor device attached to one surface and a heat receiving portion of an U-shaped or L-shaped heat pipe embedded in the other surface, and a plurality of fins are attached to heat dissipating portions of the U-shaped heat pipe to dissipate heat. In order to improve the performance of a cooling device with the above-described structure, it is effective to make the temperature of a heat receiving member with an attached device uniform. When cooling is provided while air is supplied to a heat dissipating portion, the temperature of the air generally increases in a downstream direction. The heat receiving member and power semiconductor device tend to have higher temperatures on the downstream side. Conventional known structures for making the temperature of a heat receiving member uniform include a structure in which fins in a natural-draft heat pipe cooler are placed such that the spacing between downstream ones (upper ones) is smaller than the spacing between upstream ones (lower ones), as disclosed in Japanese Patent Laid-Open Publication No. 2000-161880 (Patent Document 1).

In the conventional structure, the temperature of the heat receiving member may be higher at an upstream part with the widely spaced fins, and temperature rises at the heat receiving member may not be sufficiently uniform. In order to reduce the temperature of the heat receiving member on the upstream side, the process of increasing the number of fins at the upstream part is conceivable. However, fine adjustment of the dissipation capacity by increasing or decreasing the number of fins is actually difficult. In addition, the process of increasing the number of fins by decreasing the spacing between fins may result in increase in ventilation resistance to increase the maximum temperature of the heat receiving member.

### SUMMARY OF THE INVENTION

It is an object of the present invention to provide a cooling device which can sufficiently cool a heater element by making temperature rises at a heat receiving member uniform so as to reduce the maximum temperature of the heat receiving member and a small high-power electric conversion device including the cooling device.

In order to achieve the above-described object, according to the present invention, there is provided a cooling device including a plurality of power semiconductor devices, a heat receiving member, a plurality of heat pipes, and a plurality of heat dissipating fins, the plurality of power semiconductor devices being attached to one side of the heat receiving member, respective heat receiving portions of the plurality of heat pipes being attached to the other side of the heat receiving member, the plurality of heat dissipating fins being attached to heat dissipating portions extending upward from the heat receiving portions of the heat pipes, the heat dissipating fins being exposed to cooling air, wherein the number of heat dissipating portions of the heat pipes per unit area of the heat receiving member is larger on the downstream side of the cooling air than on the upstream side.

The amount of heat dissipated can be more finely adjusted by changing the number and arrangement of heat pipes than by changing the number of fins because the former causes little variation in pressure loss of cooling air. Since the balance among the amounts of heat dissipated can be appropriately adjusted so as not to raise the temperature of the heat receiving member on the upstream side, the temperature of the heat receiving member is more uniform. Accordingly, a cooling device which can sufficiently cool a power semiconductor device can be obtained, and a small high-power electric conversion device including the cooling device can be achieved.

### BRIEF DESCRIPTION OF THE DRAWINGS

Figure. 1 is a vertical cross-sectional view of an electric conversion device according to an embodiment of the present invention;
Figure 2 is a horizontal cross-sectional view of the electric conversion device according to the embodiment of the present invention;
Figure 3 is a view showing an arrangement of heat pipes according to the embodiment of the present invention;
Figure 4 is a view showing another arrangement of heat pipes according to the embodiment of the present invention;
Figure 5 is a view showing a configuration in which the electric conversion device according to the present invention is mounted on a railway car;
Figure 6 is a vertical cross-sectional view of an electric conversion device according to another embodiment of the present invention;
Figure 7 is a view showing an arrangement of heat pipes according to the other embodiment of the present invention; and
Figure 8 is a view showing a configuration in which the electric conversion device according to the other embodiment of the present invention is mounted on a railway car.

Reference Signs List
- 1: heat pipe
- 2: heat receiving member

- 3: power semiconductor module
- 4: fin

### DETAILED DESCRIPTION OF THE PREFERRED EMBODIMENTS

Embodiments of the present invention will be described with reference to the drawings.

### [First Embodiment]

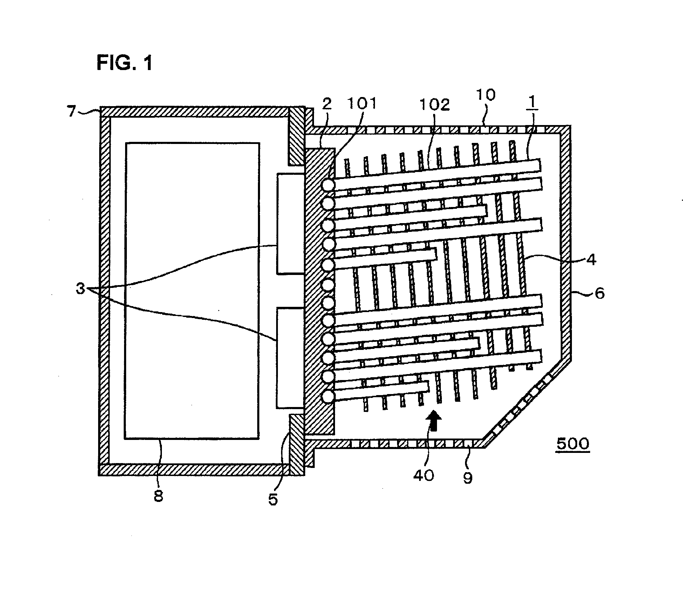

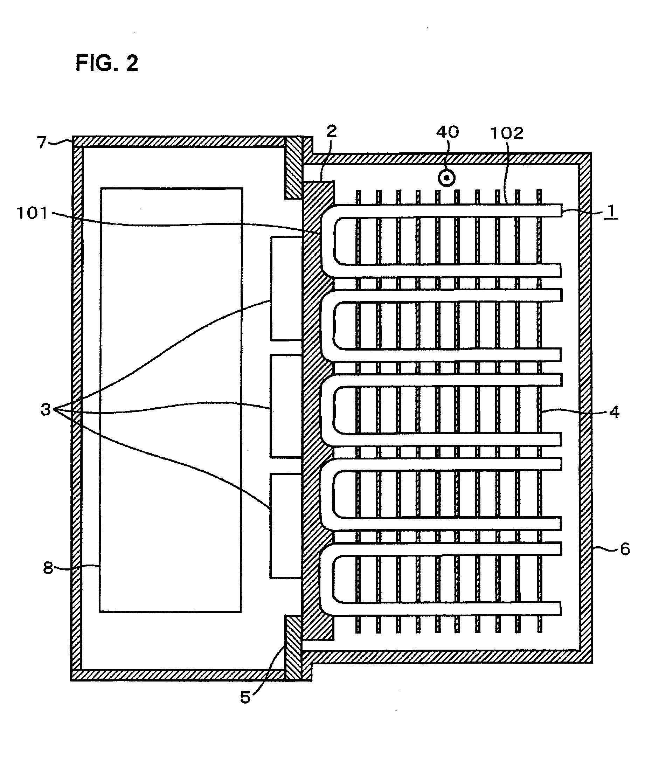

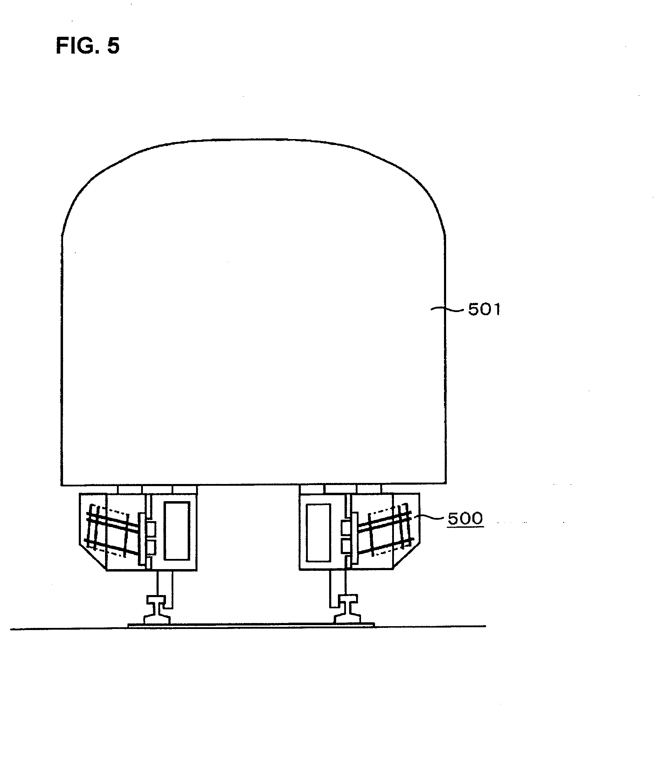

FIG. 1 shows a vertical cross-sectional view of a cooling device according to an embodiment of the present invention, and Figure 2 shows a horizontal cross-sectional view. Figure 5 shows a configuration when an electric conversion device according to the present embodiment is mounted on a railway car. An electric conversion device according to the present invention is provided, e.g., under the floor of a railway car and controls the rotational speed of an electric motor which drives the car by changing the frequency of power supplied to the electric motor. Referring to Figure 5, a power conversion device 500 is fixed to a car body 501 while the power conversion device 500 hangs down therefrom. Referring next to FIGS. 1 and 2, a power semiconductor module 3 including devices such as IGBTs (Insulated Gate Bipolar Transistors) and FWDs (Free Wheel Diodes) is placed on one side of a heat receiving member 2 made of a metal (e.g., an aluminum alloy). The power semiconductor modules 3 constitute an inverter. The power semiconductor modules 3 are each fixed to the heat receiving member 2 via a member of grease (not shown) by a screw or the like (not shown). The heat receiving member 2 is fixed to a support member 5. A circuit component 8 (e.g., an IGBT drive circuit) is placed on the power semiconductor module 3 side of the heat receiving member 2. A part of the power conversion device which includes the placed power semiconductor modules 3 is sealed in a case 7. Heat receiving portions 101 of U-shaped heat pipes 1 are embedded in the heat receiving member 2 on the side opposite to the side where the power semiconductor modules 3 are placed and are thermally connected to the heat receiving member 2 by soldering or the like. Heat dissipating portions 102 as two end parts of each U-shaped heat pipe 1 extend upward from the heat receiving member 2. The heat dissipating portions 102 include a plurality of fins 4. A cover 6 is provided on the heat pipe 1 side of the support member 5. The cover 6 includes openings 9 formed in a lower surface and openings 10 formed in an upper surface. Air taken in through the openings 9 at a lower part of the cover 6 flows upward by natural convection, as indicated by an arrow 40, and is discharged through the openings 10 at an upper part of the cover 6.

The operation of cooling the power semiconductor modules 3 will be described. Heat generated when power semiconductor devices inside the power semiconductor modules 3 operate is transmitted to the heat receiving member 2 and reaches the heat receiving portions 101 of the heat pipes 1. Each heat pipe 1 is filled with coolant (e.g., pure water or hydrofluorocarbon). The coolant heated by the heat receiving portion 101 evaporates into gas and moves to the heat dissipating portions 102. The coolant cooled at the heat dissipating portions 102 by air condenses back into liquid. As shown in Figure 1, the heat dissipating portions 102 are tilted at about 10°. The coolant condensed at the heat dissipating portions 102 returns to the heat receiving portion 101 by gravity. As described above, the coolant moves while repeating evaporation and condensation, which dissipates heat at the heat receiving member 2 into air.

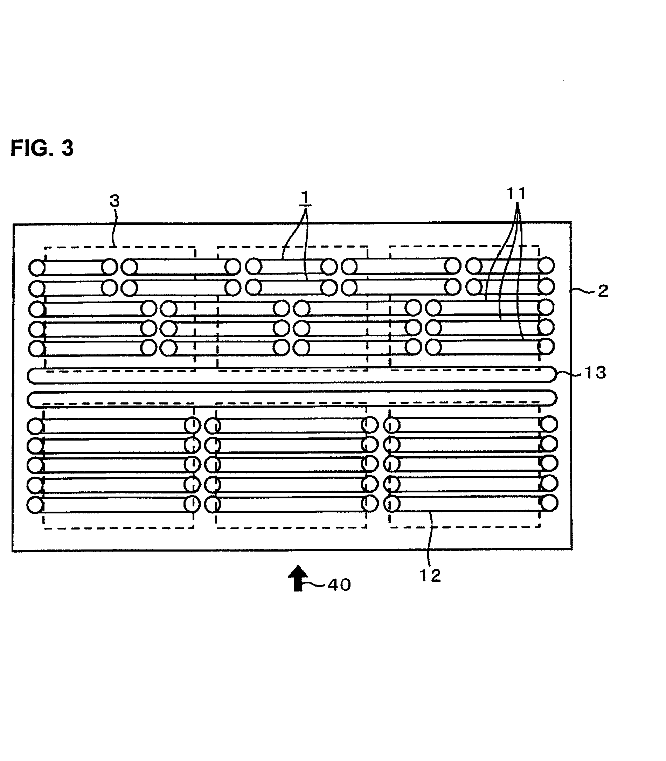

Figure 3 shows the shapes and arrangement of the heat pipes at the heat receiving member 2. As shown in Figure 3, each heat pipe is arranged such that its longitudinal direction is substantially perpendicular to a direction indicated by the arrow 40 in which cooling air flows. The number of heat dissipating portions of the heat pipes 1 placed in two upper tiers of the heat receiving member 2 is 10 per tier. In contrast, the number of heat dissipating portions of heat pipes 12 placed in five lower tiers of heat receiving member 2 is 6 per tier. The number of heat dissipating portions is smaller than at the upper part of the heat receiving member 2. The number of heat dissipating portions of heat pipes 11 at a middle part of the heat receiving member 2 (in the third to fifth tiers) is 8 per tier, which is intermediate between 10 and 6. That is, the heat pipes are arranged such that the number of heat dissipating portions of the heat pipes per unit area of the heat receiving member 2 is larger on the downstream side of cooling air than on the upstream side.

In cooling by natural convection, the temperature tends to be highest at and around the upper central power semiconductor module 3. The power semiconductor module 3 is located on the downstream side of a natural convection current where the temperature of air is high and is hard to dissipate heat to the left and to the right due to the left and right modules. A larger number of ones of the heat dissipating portions are concentrated at the module.

In order to enhance the cooling effect by disturbing the flow of cooling air passing along fin parts corresponding to the module, the configuration is made so that cooling air from the upstream side directly hits the heat pipes on the downstream side. More specifically, the heat pipes are arranged such that the heat dissipating portions of the heat pipes in adjacent tiers, the numbers of which are different, do not overlap with each other when viewed from the inlet side of air (in the flow direction of cooling air). Straight heat pipes 13 for heat equalization without a portion which dissipates heat toward the fins 4 are further provided at the heat receiving member 2. The heat pipes 13 serve to equalize heat in a direction, transverse to the flow direction of cooling air of the heat receiving member 2, in which the heat receiving member 2 is likely to exhibit a wide range of temperature variation. This prevents the temperature of the heat receiving member 2 from being locally high at a central part.

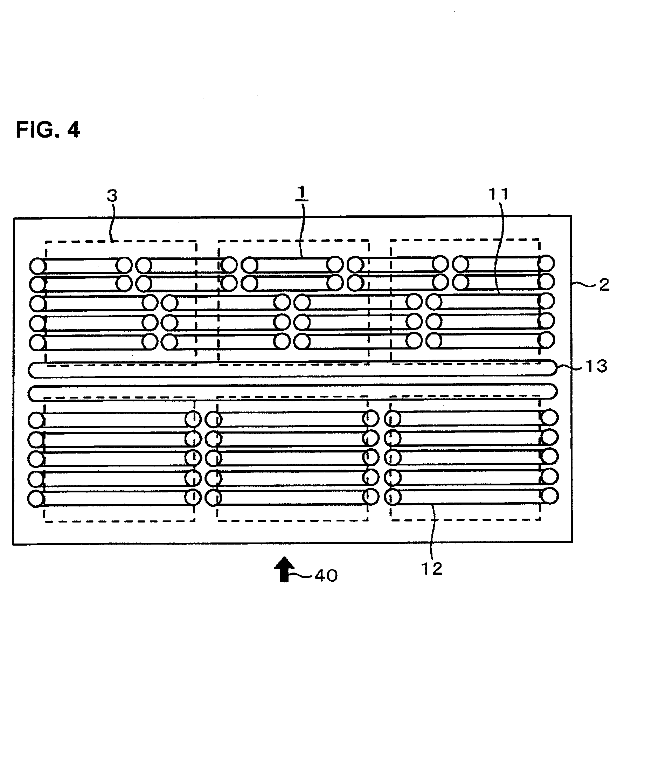

Figure 4 shows another example of the arrangement of the heat pipes at the heat receiving member 2. The arrangement allows some overlap in a ventilation direction between the heat dissipating portions in adjacent tiers with the different numbers of heat pipes, and the U-shaped heat pipes 1 placed in the two upper tiers of the heat receiving member 2 are all set to the same length. According to the structure, the productivity is improved by reducing the number of kinds of U-shaped pipes, and the cooling performance can be expected to compare favorably with that of the structure in Figure 3.

The above-described structure allows minimization of a loss in pressure of air on the upstream side of cooling by natural convection and dissipation of a sufficient amount of heat on the downstream side. Accordingly, temperature rises at the heat receiving member 2 are more uniform, and a rise in temperature of the heat receiving member 2 and even a rise in temperature of the power semiconductor modules 3 can be reduced. Note that the number of fins may be reduced on the upstream side and be increased on the downstream side, in addition to the adjustment of the number of heat pipes. Temperature rises at the heat receiving member 2 can be made more uniform by combining adjustment of the number of fins and adjustment of the number of heat pipes.

### [Second Embodiment]

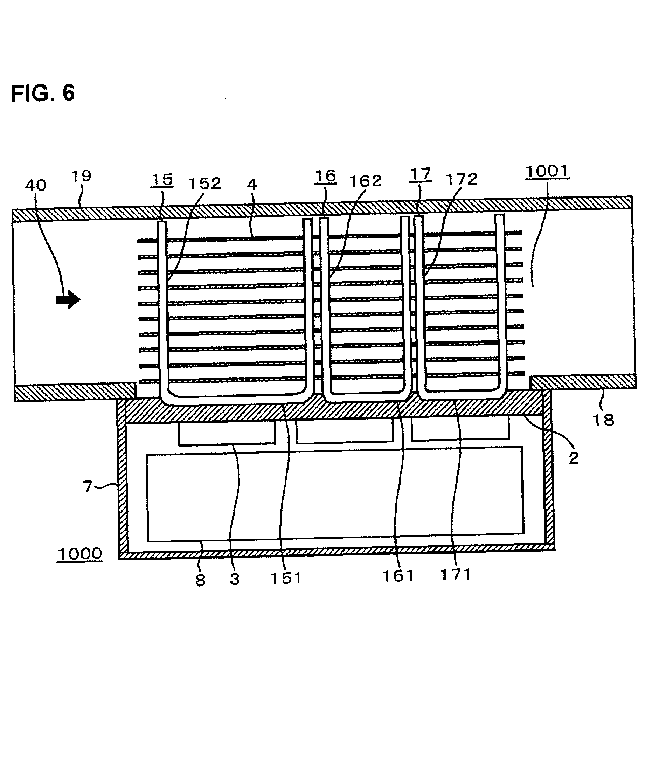

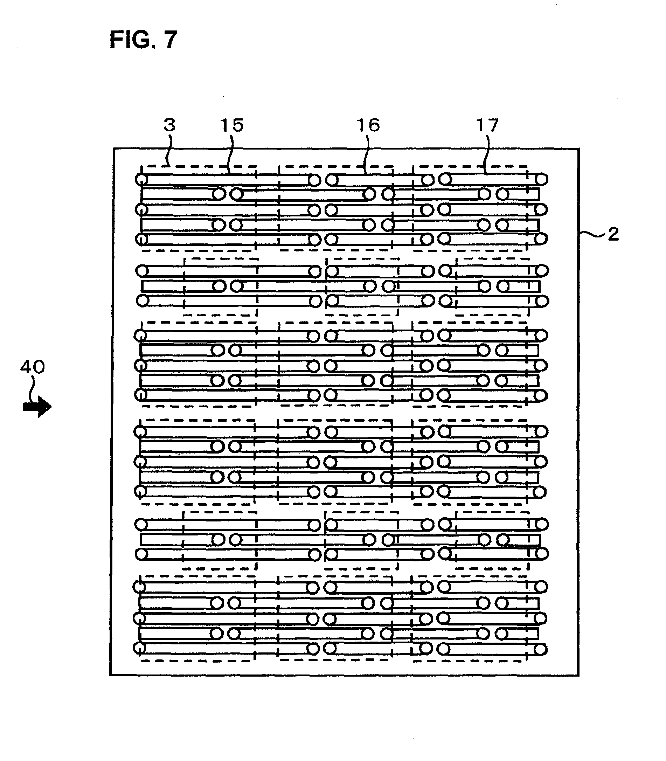

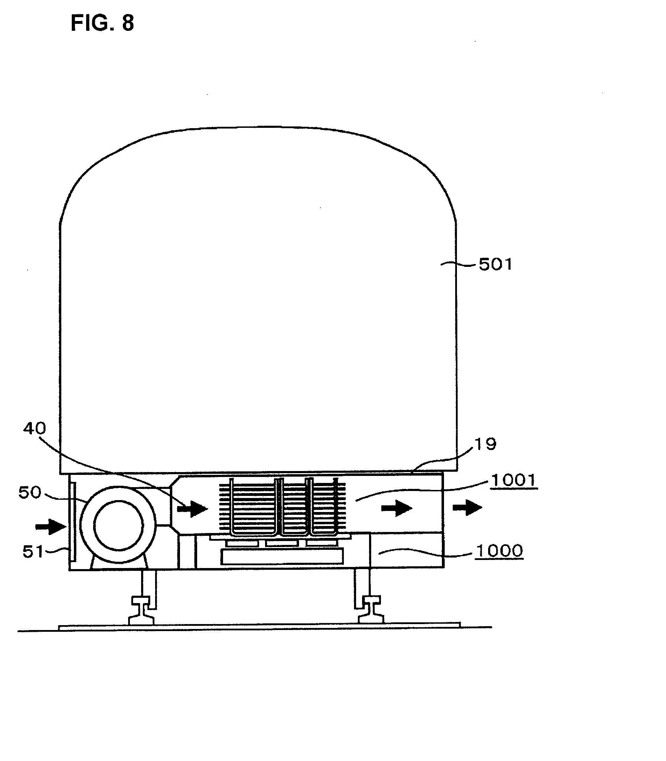

Figure 6 shows a vertical cross-sectional view of a cooling device according to another embodiment of the present invention, and Figure 7 shows an arrangement of heat pipes at a heat receiving member 2 according to the present embodiment. Figure 8 shows a configuration when an electric conversion device according to the present embodiment is mounted on a railway car. Referring to Figure 8, a power conversion device 1000 is fixed to a car body 501. An arrow 40 indicates a direction in which cooling air flows. Cooling air is taken in through a suction grill 51 by a blower 50 and is supplied to a cooling device 1001 of the power conversion device 1000. Referring to FIGS. 6 and 7, a power semiconductor module 3 including devices such as IGBTs and FWDs is placed on one side of the heat receiving member 2 (on the lower side in Figure 6). The power semiconductor modules 3 constitute an inverter. The power semiconductor modules 3 are each fixed to the heat receiving member 2 via a member of, e.g., grease (not shown) by a screw or the like (not shown). The heat receiving member 2 is fixed to a structural member 18 of a duct 19. An electronic component 8 (e.g., an IGBT drive circuit) is placed on the power semiconductor module 3 side of the heat receiving member 2. A part of the power conversion device which includes the placed power semiconductor modules 3 is sealed in a case 7. Heat receiving portions 151 of U-shaped heat pipes 15 are embedded in the heat receiving member 2 on the side opposite to the side where the power semiconductor modules 3 are placed and are thermally connected to the heat receiving member 2 by soldering or the like. Heat dissipating portions 152 as two end parts of each U-shaped heat pipe 15 extend upward from the heat receiving member 2. A plurality of fins 4 made of metal (e.g., aluminum or copper) are connected to the heat dissipating portions 152 by press fitting or the like. The heat dissipating portions 152 and fins 4 are placed inside the duct 19. The duct 19 receives cooling air supplied by the blower. The arrow 40 indicates the direction of cooling air. As shown in Figure 7, each heat pipe is arranged such that its longitudinal direction is substantially parallel to the direction

indicated by the arrow 40, in which cooling air flows. Heat pipes including heat receiving portions 161 and 171 shorter than the heat receiving portions 151 of the heat pipes 15 on the upstream side are used as heat pipes 16 and 17, respectively, on the downstream side such that the number of heat dissipating portions of the heat pipes, extending upward toward the fins, per unit area of the heat receiving member 2 is larger on the downstream side of cooling air than on the upstream side. The above-described structure allows minimization of a loss in pressure of air on the upstream side and dissipation of a sufficient amount of heat on the downstream side. Accordingly, temperature rises at the heat receiving member 2 are more uniform, and a rise in temperature of the heat receiving member 2 and even a rise in temperature of the power semiconductor modules 3 can be reduced.

As has been described above, according to the present embodiment, the temperature of a heat receiving member with attached power semiconductor devices can be made uniform, and a rise in temperature at the power semiconductor devices can be reduced. This allows reduction in size and weight of a cooling device. Note that the number of fins may be reduced on the upstream side and be increased on the downstream side, in addition to the adjustment of the number of heat pipes. Temperature rises at the heat receiving member 2 can be made more uniform by combining adjustment of the number of fins and adjustment of the number of heat pipes.

## Claims

1. A cooling device comprising a plurality of power semiconductor devices, a heat receiving member, a plurality of heat pipes, and a plurality of heat dissipating fins, the plurality of power semiconductor devices being attached to one side of the heat receiving member, respective heat receiving portions of the plurality of heat pipes being attached to the other side of the heat receiving member, the plurality of heat dissipating fins being attached to heat dissipating portions extending upward from the heat receiving portions of the heat pipes, the heat dissipating fins being exposed to cooling air,
**characterized in that** the heat pipes are arranged such that the number of heat dissipating portions of the heat pipes per unit area of the heat receiving member is larger on the downstream side of the cooling air than on the upstream side.

2. The cooling device according to claim 1, **characterized in that**
the cooling air, to which the heat dissipating fins are exposed, is provided by natural convection,
the heat pipes are arranged in a plurality of tiers such that a longitudinal direction of the heat pipes is substantially perpendicular to a direction in which the cooling air flows, and
the heat pipes in adjacent ones of the tiers, the numbers of which are different in the longitudinal direction, are arranged such that the heat dissipating portions do not overlap with each other in the direction in which the cooling air flows.

3. The cooling device according to claim 1 or 2, **characterized in that**
a straight heat pipe without the heat dissipating portion is embedded in the heat receiving member.

4. The cooling device according to claim 1, **characterized in that**
the cooling air, to which the heat dissipating fins are exposed, is provided by a blower, and
the heat pipes are arranged such that a longitudinal direction of the heat pipes is substantially parallel to a direction in which the cooling air flows.

5. The cooling device according to any one of claims 1 to 4, **characterized in that**
the number of heat dissipating fins attached to the heat dissipating portions on the upstream side of the cooling air is smaller than the number of heat dissipating fins attached to the heat dissipating portions on the downstream side.

6. A power conversion device comprising a cooling device according to any one of claims 1 to 5.
